(19) Europäisches Patentamt
European Patent Office
Office européen des brevets

(11) **EP 4 485 546 A1**

(12) **EUROPEAN PATENT APPLICATION**
published in accordance with Art. 153(4) EPC

(43) Date of publication:
**01.01.2025 Bulletin 2025/01**

(21) Application number: **22928815.4**

(22) Date of filing: **17.08.2022**

(51) International Patent Classification (IPC):
*H01L 29/78* (2006.01)    *H01L 29/12* (2006.01)
*H01L 29/47* (2006.01)    *H01L 29/872* (2006.01)

(52) Cooperative Patent Classification (CPC):
**H01L 29/12; H01L 29/47; H01L 29/78; H01L 29/872**

(86) International application number:
**PCT/JP2022/031134**

(87) International publication number:
**WO 2023/162294 (31.08.2023 Gazette 2023/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.02.2022 JP 2022027445**

(71) Applicant: **Hitachi, Ltd.
Tokyo 100-8280 (JP)**

(72) Inventors:
• **SUTO, Takeru
Tokyo 100-8280 (JP)**
• **MORI, Yuki
Tokyo 100-8280 (JP)**
• **SUEMATSU, Tomoka
Tokyo 100-8280 (JP)**

(74) Representative: **Mewburn Ellis LLP
Aurora Building
Counterslip
Bristol BS1 6BX (GB)**

(54) **SEMICONDUCTOR DEVICE**

(57)    A semiconductor device has MOSFET 1Q and a shut-off function circuit for detecting an overcurrent that flows to the MOSFET 1Q and limiting the overcurrent. The shut-off function circuit has MOSFETs 2Q and 3Q, a resistor element 4Q, and a Schottky barrier diode 5Q. The Schottky barrier diode 5Q has a gate wiring GW and a drain region ND3. The gate wiring GW is electrically connected to gate electrodes GE1 and GE2 and a drain region ND3, while the source electrode SE is electrically connected to source regions NS1 and NS3, body regions PB1 and PB2, and the resistor element 4Q. The source region NS2 is electrically connected to the source region NS3 and a source electrode SE via the resistor element 4Q, while a gate electrode GE3 is electrically connected to the source region NS2 by a wiring 10.

FIG. 4

EP 4 485 546 A1

**Description**

Technical Field

The present invention relates to a semiconductor device, in particular, to a semiconductor device using a semiconductor substrate composed of silicon carbide.

Background Art

In Power MOSFET (Metal Oxide Semiconductor Field Effect Transistor), a power MOSFET (Si power MOSFET) using a silicon (Si) substrate has conventionally been a mainstream. The field intensity in silicon carbide (SiC) to dielectric breakdown is about an order of magnitude larger than that in Si.

In a power MOSFET (SiC power MOSFET) using an SiC substrate, compared with an Si power MOSFET, the thickness of a drift layer for retaining a breakdown voltage can therefore be reduced to about 1/10 to make the impurity concentration of the drift layer about 100 times higher. As a result, an element resistance can theoretically be made lower by more than three orders of magnitude in the SiC power MOSFET. In addition, the band gap of SiC is about three times larger than that of Si so that the on resistance of the SiC power MOSFET, if the breakdown voltage is the same, can be made lower and enables even the operation under high temperature conditions. SiC semiconductor elements are therefore expected to have performance superior to that of Si semiconductor elements.

As a using example of the power MOSFET, two power MOSFETs connected in series to each other are connected to a load and the on-operation and off-operation of these two power MOSFETs are switched alternately to adjust a potential for the load. In one power MOSFET, a current flows but no voltage is applied in the on state, while a current does not flow but a voltage is applied in the off state. When one of the power MOSFETs is in the on state and the other power MOSFET is turned ON due to a failure, malfunction, or the like, a short circuit state that causes conduction of both a current and a voltage occurs in the one of the power MOSFETs.

By the occurrence of the short circuit state, the power MOSFET generates heat due to a large current and after the lapse of a certain time, it is destroyed. In this case, the power MOSFET is still in the short circuit state and failure, fire, or the like occurs in an electrical apparatus having the power MOSFET thereon. It is therefore an ordinary practice to load a protection circuit on an electric apparatus. Before the power MOSFET is destroyed, this protection circuit protects the power MOSFET from short circuit. A certain amount of time is however necessary until the protection circuit detects the short circuit state and finishes the shut-off of the short circuit of the power MOSFET. The power MOSFET is required to withstand this short circuit state during this period.

For example, Patent Literature 1 discloses a semiconductor device having an overcurrent limiting circuit for detecting and limiting an overcurrent flowing to a power MOSFET.

Citation List

Patent Literature

Patent Literature 1: Japanese Unexamined Patent Application Publication No. 2003-332446

Summary of Invention

Technical Problem

For obtaining a power MOSFET having improved performance, it is effective to reduce its on resistance or the like to form a low loss device structure. On the other hand, enhancement of loss reduction accelerates the flow of a large current at the time of short circuit, which reduces the time (short-circuit withstand time) during which the power MOSFET can withstand the short circuit state. For example, the short-circuit withstand time of the Si power MOSFET is about 10 μsec, but drastic enhancement of loss reduction in the SiC power MOSFET may decrease the short-circuit withstand time to about 2 μsec. Even a loss-increased device structure may be used in consideration of such short-circuit withstand time.

Even when the power MOSFET is equipped with an overcurrent limiting circuit as described in Patent Literature 1, however, it has such a problem that wiring inductance increases in an electric path leading to the power MOSFET or in an electric path between elements constituting the overcurrent limiting circuit. This problem becomes more marked when such electric paths are realized by post processing.

When the wiring inductance increases, a malfunction may occur in the power MOSFET due to noise. A low pass filter may be used for the noise reduction, but it takes time for integration, for example, it takes 3 μsec or more. Then, in the SiC power MOSFET, the short circuit shut-off cannot be achieved in time.

**EP 4 485 546 A1**

In consideration of these points, it is possible to provide a power MOSFET having low loss and shortened short-circuit withstand time by forming a circuit equipped with a shut-off function in one semiconductor chip and thereby minimizing the wiring inductance. A main object of the present application is to develop such a SiC power MOSFET and thereby provide a semiconductor device (semiconductor chip) having improved performance and ensured reliability.

Objects, and novel features other than the above will be apparent from the description of the present specification and accompanied drawings.

Solution to Problem

Among embodiments disclosed in the present application, a typical one of summary is briefly described as follows.

A semiconductor device of an embodiment, includes: an n type semiconductor substrate having a front surface and a back surface and having silicon carbide; a source electrode, a gate wiring, and a first wiring formed over the front surface of the semiconductor substrate; a p type first body region formed in the semiconductor substrate on the front surface side of the semiconductor substrate; a p type second body region formed in the semiconductor substrate on the front surface side of the semiconductor substrate; a drain electrode formed below the back surface of the semiconductor substrate; a first MOSFET; a second MOSFET; a third MOSFET; a Schottky barrier diode; and a resistor element. Here, the first MOSFET includes: an n type first source region formed in the first body region; an n type first drain region formed, on the back surface side of the semiconductor substrate, in the semiconductor substrate and electrically connected to the drain electrode; and a first gate electrode formed over the front surface of the semiconductor substrate via a first gate insulating film. Further, the second MOSFET includes: an n type second source region formed in the second body region; the first drain region; and a second gate electrode formed over the front surface of the semiconductor substrate via a second gate insulating film. Further, the third MOSFET includes: an n type third source region formed in the second body region; an n type third drain region formed in the second body region; and a third gate electrode formed over the front surface of the semiconductor substrate via a third gate insulating film. Further, the Schottky barrier diode is constituted by Schottky junction of a conductive material contained in the gate wiring and the third drain region. The gate wiring is electrically connected to the first gate electrode, the second gate electrode, and the third drain region. The source electrode is electrically connected to the first source region, the third source region, the first body region, the second body region, and the resistor element. The second source region is electrically connected to the third source region and the source electrode via the resistor element, and the third gate electrode is electrically connected to the second source region by the first wiring. Furthermore, the second MOSFET, the third MOSFET, the Schottky barrier diode, and the resistor element constitute a shut-off function circuit that detects an overcurrent flowing to the first MOSFET and limits the overcurrent.

A semiconductor device of one embodiment, includes: an n type semiconductor substrate having a front surface and a back surface and having silicon carbide; a source electrode, a gate wiring, and a first wiring formed over the front surface of the semiconductor substrate; a p type first body region formed in the semiconductor substrate on the front surface side of the semiconductor substrate; a p type second body region formed in the semiconductor substrate on the front surface side of the semiconductor substrate; a drain electrode formed below the back surface of the semiconductor substrate; a first MOSFET; a third MOSFET; a JFET; a Schottky barrier diode; and a resistor element. Here, the first MOSFET includes: an n type first source region formed in the first body region; an n type first drain region formed in the semiconductor substrate on the back surface side of the semiconductor substrate and electrically connected to the drain electrode; and a first gate electrode formed over the front surface of the semiconductor substrate via a first gate insulating film. Further, the third MOSFET includes: an n type third source region formed in the second body region; an n type third drain region formed in the second body region; and a third gate electrode formed over the front surface of the semiconductor substrate via a third gate insulating film. Further, the resistor element is constituted by a fourth MOSFET, and the fourth MOSFET includes: an n type second diffusion region formed in the second body region; an n type third diffusion region extending from the second body region to the semiconductor substrate between the first body region and the second body region; and a fourth gate electrode formed over the front surface of the semiconductor via a fourth gate insulating film. Further, the JFET includes: the first body region; the second body region; the third diffusion region; and the semiconductor substrate between the first body region and the second body region. The Schottky barrier diode is constituted by Schottky junction of a conductive material contained in the gate wiring and the third drain region. Further, the gate wiring is electrically connected to the first gate electrode, the fourth gate electrode, and the third drain region, the source electrode is electrically connected to the first source region, the third source region, the second diffusion region, the first body region, and the second body region, and the third gate electrode is electrically connected to the third diffusion region by the first wiring. Furthermore, the JFET, the third MOSFET, the Schottky barrier diode, and the resistor element constitute a shut-off function circuit that detects an overcurrent flowing to the first MOSFET and limits the overcurrent.

Advantageous Effects of Invention

According to one embodiment, it is possible to improve performance of a semiconductor device and to ensure

3

reliability of the semiconductor device.

Brief Description of Drawings

Fig. 1 is a circuit diagram showing a semiconductor device of First Embodiment.
Fig. 2 is a perspective view showing the semiconductor device of First Embodiment.
Fig. 3 is a perspective view showing the semiconductor device of First Embodiment.
Fig. 4 is a cross-sectional view showing the semiconductor device of First Embodiment.
Fig. 5 is a schematic view showing a problem which occurs when a PN diode is used instead of a Schottky barrier diode.
Fig. 6 is a perspective view showing a semiconductor device of First Modification.
Fig. 7 is a cross-sectional view showing a semiconductor device of Second Embodiment.
Fig. 8 is a graph showing the results of simulation conducted by the inventors of the present application.
Fig. 9 is a cross-sectional view showing a semiconductor device of Third Embodiment.
Fig. 10 is a graph showing the results of simulation conducted by the inventors of the present application.
Fig. 11 is a graph showing the results of simulation conducted by the inventors of the present application.
Fig. 12 is a plan view showing a semiconductor device of Fourth Embodiment.
Fig. 13 is a plan view showing a semiconductor device of Second Modification.
Fig. 14 is a circuit diagram showing a portion of a semiconductor device of Fifth Embodiment.
Fig. 15 is a table showing the results of simulation conducted by the inventors of the present application.
Fig. 16 is a perspective view showing a portion of a semiconductor device of Sixth Embodiment.
Fig. 17 is a cross-sectional view showing a portion of the semiconductor device of Sixth Embodiment.
Fig. 18 is a cross-sectional view showing a portion of the semiconductor device of Sixth Embodiment. Description of Embodiments

Embodiments of the present invention will hereinafter be described in detail based on accompanying drawings. In all the drawings for describing the embodiments, members having the same function are denoted by the same reference numerals and overlapping descriptions are omitted. In the following embodiments, unless otherwise particularly necessary, a description on the same or similar portions is not repeated in principle.
In the description of the present application, a direction X, a direction Y and a direction Z intersect with each other and are orthogonal to each other. In the present application, a description will be made by defining the direction Z as a perpendicular direction, an up-and-down direction, a height direction, or a thickness direction, each in a structure. The term "planar view" as used herein means viewing of a plane composed of the direction X and the direction Y from the direction Z.

(First Embodiment)

<Constitution of semiconductor device>

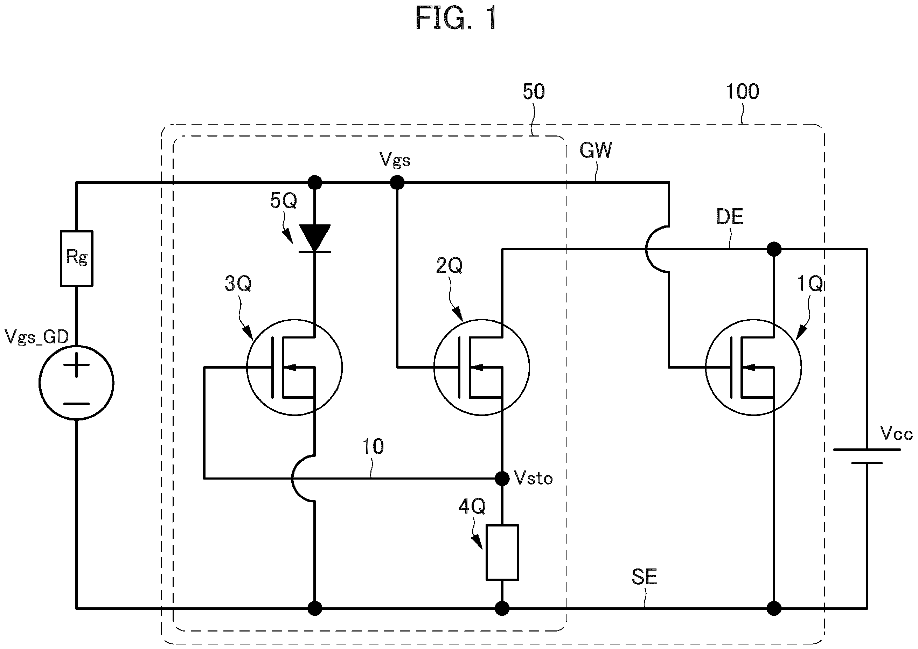

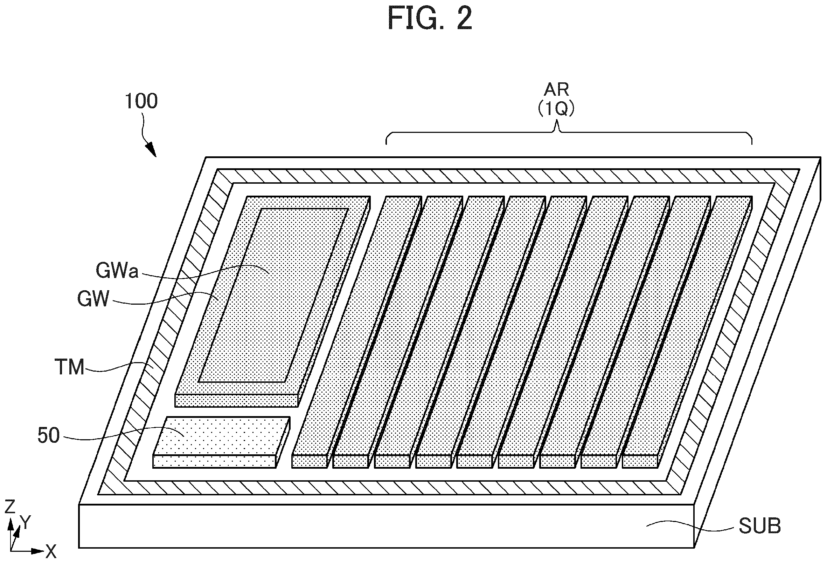

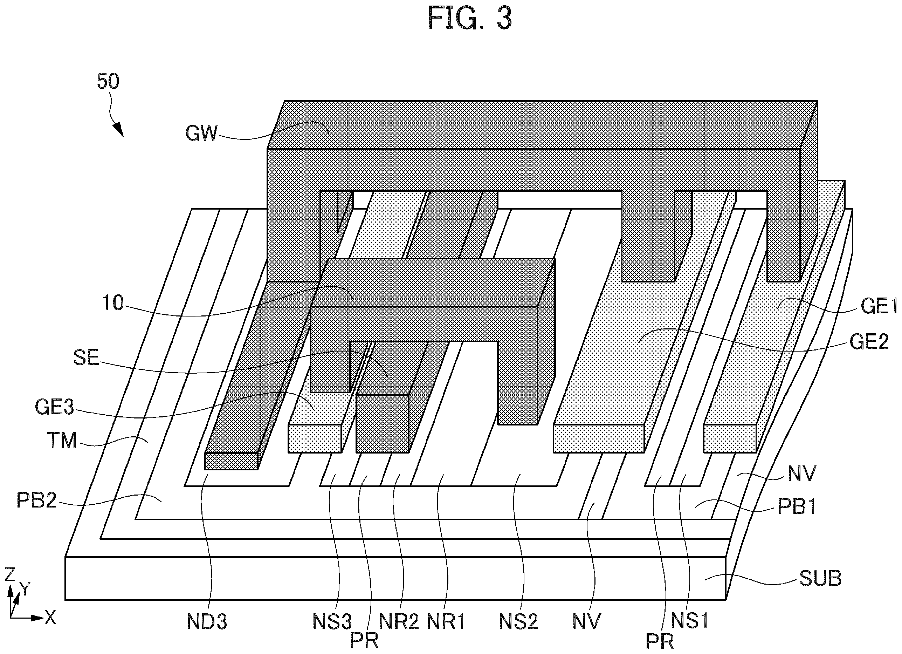

Fig. 1 is a circuit diagram showing a semiconductor device 100 of First Embodiment. The semiconductor device 100 has a gate wiring GW, a drain electrode DE, and a source electrode SE and is connected to an electric apparatus. The gate wiring GW is connected to a positive terminal of a gate driver voltage Vg_GD via a gate resistance Rg. The drain electrode DE is connected to a positive terminal of a power supply voltage Vcc of the electric apparatus. The source electrode SE is connected to a negative terminal of the gate driver voltage Vg_GD and a negative terminal of the power supply voltage Vcc.
The semiconductor device 100 is a semiconductor chip and has a shut-off function circuit 50 and MOSFET 1Q. The MOSFET 1Q is an SiC power MOSFET and is a main device of the semiconductor device 100.
The shut-off function circuit 50 is a circuit for detecting an overcurrent that flows to the MOSFET 1Q and limiting the overcurrent. In First Embodiment, the shut-off function circuit 50 is composed of a MOSFET 2Q, a MOSFET 3Q, a resistor element 4Q, a Schottky barrier diode 5Q, and a wiring 10. The MOSFET 2Q is used as a current detection element and the MOSFET 3Q is used as an overcurrent shutting-off element.
The structure of the semiconductor device 100 and the electrical connection relationship between the shut-off function circuit 50 and the MOSFET 1Q will hereinafter be described using Fig. 2 to Fig. 4.
As shown in Fig. 2 and Fig. 3, the semiconductor device 100 has a semiconductor substrate SUB having a front surface and a back surface. The semiconductor substrate SUB has, above the front surface thereof, the gate wiring GW, the source electrode SE, and the wiring 10. A large portion of the semiconductor substrate SUB is an active region AR in which the MOSFET 1Q is formed. Although not shown in Fig. 2, a large portion of the source electrode SE covers a portion above the active region AR. The wiring 10, a portion of the source electrode SE, and a portion of the gate wiring GW are, as shown in Fig. 3, provided in the shut-off function circuit 50.

It is to be noted that actually, the semiconductor device 100 has, in the active region AR thereof, a plurality of MOSFETs and they are connected in parallel to each other. The aforesaid MOSFETs connected in parallel to each other are considered as one MOSFET from the standpoint of an equivalent circuit and defined as the MOSFET 1Q.

The gate wiring GW has a gate pad region Gwa for connecting to an external connection member such as bonding wire or clip (copper plate). The source electrode SE also has a source pad region for connecting to the external connection member. By connecting the external connection members onto the gate pad region Gwa and onto the source pad region, the semiconductor device 100 is electrically connected to another semiconductor chip, a wiring substrate, a terminal of an electrical apparatus, or the like.

The semiconductor substrate SUB has, on the front surface side of the semiconductor substrate SUB, a p type termination region TM. In a planar view, the termination region TM surrounds the MOSFET 1Q and the shut-off function circuit 50.

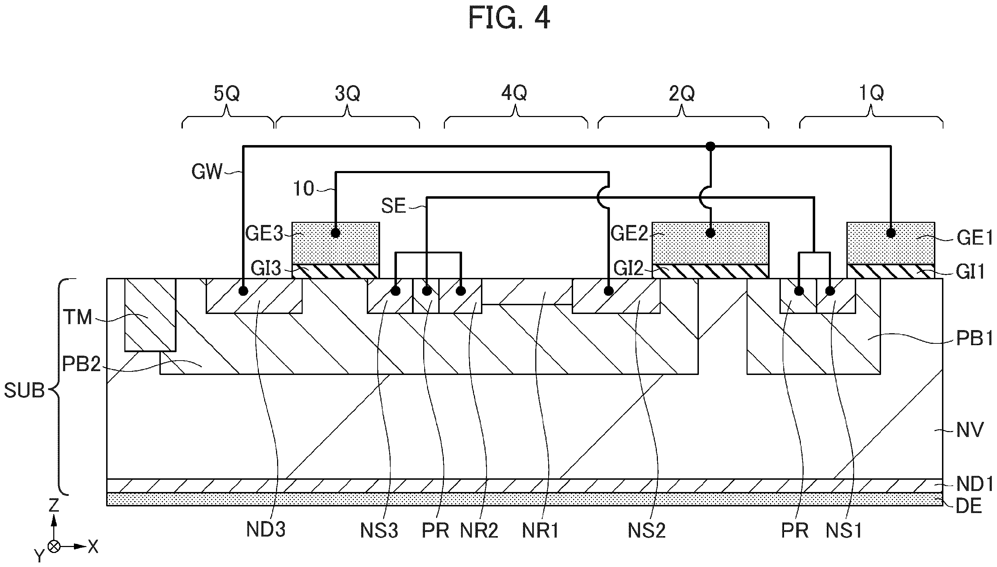

As shown in Fig. 4, the semiconductor substrate SUB has a lightly doped n type drift region NV. The semiconductor substrate SUB described herein is an n type silicon carbide substrate (SiC substrate) and the semiconductor substrate SUB itself constitutes the drift region NV. It is to be noted that the drift region NV may be a stack of an n type SiC substrate and an n type SiC layer obtained by introducing and growing phosphorus (P) on the SiC substrate by the epitaxial growth method. In the present application, such a stack will be described as the semiconductor substrate SUB.

The semiconductor substrate SUB has, on the front surface side of the semiconductor substrate SUB, a p type body region PB1 and a p type body region PB2. The body region PB1 and the body region PB2 are physically separated from each other by the drift region NV that is positioned therebetween. The body region PB2 is in contact with the termination region TM.

The body region PB1 has therein an n type source region NS1. The source region NS1 has an impurity concentration higher than that of the drift region NV.

The body region PB2 has therein an n type source region NS2, an n type source region NS3, an n type drain region ND3, an n type diffusion region NR1, and an n type diffusion region NR2. The source region NS2, the source region NS3, the drain region ND3, and the diffusion region NR2 have an impurity concentration higher than that of the drift region NV and the diffusion region NR1.

The body region PB1 and the body region PB2 each have a p type diffusion region PR. The p type diffusion region PR has an impurity concentration higher than that of the body region PB1 and the body region PB2.

A gate electrode GE1 is formed on the front surface of the semiconductor substrate SUB via a gate insulating film GI1. A gate electrode GE2 is formed on the front surface of the semiconductor substrate SUB via a gate insulating film GI2. A gate GE3 is formed on the front surface of the semiconductor substrate SUB via a gate insulating film GI3. The gate electrodes GE1 to GE3 are, for example, an n type polycrystalline silicon film. The gate insulating films GI1 to GI3 are, for example, a silicon oxide film.

The semiconductor substrate SUB has, on the back surface side of the semiconductor substrate SUB, an n type drain region ND1. The drain region ND1 has an impurity concentration higher than that of the drift region NV. The semiconductor substrate SUB has, on the back surface side thereof, a drain electrode DE. The drain electrode DE is electrically connected to the drain region ND1 and the drift region NV and supplies the drain region ND1 with a drain potential. The drain electrode DE is composed of a metal monolayer film such as an aluminum film, a titanium film, a nickel film, a gold film, or a silver film, or a stacked film obtained by stacking these metal films as needed.

Although not shown in these drawings, the gate wiring GW, the source electrode SE, and the wiring 10 are above the front surface of the semiconductor substrate SUB via an interlayer insulating film. The interlayer insulating film has therein a plurality of contact holes. By embedding the contact holes with a portion of each of the gate wiring GW, the source electrode SE, and the wiring 10, the gate wiring GW, the source electrode SE, and the wiring 10 are electrically connected to these gate electrodes and impurity regions.

The gate wiring GW, the source electrode SE, and the wiring 10 are each composed of a conductive material. Such a conductive material is composed of, for example, a stacked film of a titanium nitride film and an aluminum film formed on the titanium nitride film. Except a Schottky barrier diode 5Q which will be described later, the gate wiring GW, the source electrode SE, and the wiring 10 form an ohmic contact with the gate electrodes and the impurity regions. To form the ohmic contact, though not shown in the drawings, the gate wiring GW, the source electrode SE, and the wiring 10 and each of the gate electrodes or the impurity regions have therebetween a silicide film such as a nickel silicide film.

In First Embodiment, any of the gate wiring GW, the source electrode SE, and the wiring 10 has a multilayer wiring structure. Described specifically, a first-layer interlayer insulating film is formed above the semiconductor substrate SUB and the first-layer interlayer insulating film has thereon a first-layer conductive material. A second-layer interlayer insulating film that covers the first-layer conductive material is formed and the second-layer interlayer insulating film has thereon a second-layer conductive material. A third-layer interlayer insulating film that covers the second-layer conductive material is formed and the third-layer interlayer insulating film has thereon a third-layer conductive material.

An example of the multilayer wiring structure shown here is a three-layer structure. Described specifically, the source electrode SE is composed of the first-layer conductive material; the wiring 10 is composed of the first-layer and the second-layer conductive materials; and the gate wiring GW is composed of the first-layer, second-layer, and third-layer conductive materials. The number of the layers of the conductive material constituting the gate wiring GW, the source electrode SE, and the wiring 10 is not limited to that of the aforesaid constitution and can be changed as needed.

The MOSFET 1Q has the source region NS1, the drain region ND1, the gate insulating film GI1, and the gate electrode GE1. The MOSFET 2Q has the source region NS2, the drain region ND1, the gate insulating film GI2, and the gate electrode GE2. The MOSFET 3Q has the source region NS3, the drain region ND3, the gate insulating film GI3, and the gate electrode GE3.

The Schottky barrier diode 5Q is formed by Schottky junction between the conductive material (titanium nitride film) contained in the gate wiring GW and the drain region ND3. In First Embodiment, the resistor element 4Q is composed of the diffusion region NR1. The diffusion region NR1 has an impurity concentration lower than that of the source region NS2, the source region NS3, the drain region ND3, and the diffusion region NR2.

The gate wiring GW is electrically connected to the gate electrode GE1, the gate electrode GE2, and the drain region ND3. The source electrode SE is electrically connected to the source region NS1, the source region NS3, and the diffusion region NR2. The source electrode SE is electrically connected to the body region PB1 and the body region PB2 via the diffusion region PR.

The resistor element 4Q (diffusion region NR1) is electrically connected to the source electrode SE via the diffusion region NR2. The source region NS2 is electrically connected to the source region N3 and the source electrode SE via the resistor element 4Q. The gate electrode GE3 is electrically connected to the source region NS2 via the wiring 10.

<Operation and main advantage of semiconductor device>

Referring to Fig. 1, the operation of the semiconductor device 100 will be described. For Example, supposing that while a positive voltage is applied to the gate wiring GW, a load connected to the semiconductor device 100 causes a short circuit failure and a large current flows to the MOSFET 2Q. At this time, a portion of the large current flows via the MOSFET 2Q and the resistor element 4Q. A voltage drop occurs at the resistor element 4Q and the potential Vsto of the wiring 10 exceeds 0 V, which turns on the MOSFET 3Q. Then, a current flows to the source electrode SE from the gate wiring GW, causing a reduction in gate source voltage Vgs and suppression of a short circuit current. In short, the gate source voltage Vgs can be reduced only at the time of a large current and therefore, a short circuit current can be suppressed automatically.

In addition, in the semiconductor device 100, the MOSFET 1Q and the shut-off function circuit 50 are surrounded by the termination region TM in a planar view. When a high voltage is applied to the drain electrode DE, a high voltage is also applied to the side surface of the semiconductor device 100, which may cause dielectric breakdown in the horizontal direction. Inside the termination region TM, the shut-off function circuit 50 can be formed within a range of low voltage. The shut-off function circuit 50 can be formed near the active region AR which is a region to be protected from a short circuit. This facilitates a reduction in wiring inductance.

The MOSFET 2Q has a width of about 5 um. It is possible to arbitrarily set the resistance value of the resistor element 4Q by adjusting the impurity concentration of the diffusion region NR1 or it is also possible to set the width of the resistor element 4Q at about 1 um. The MOSFET 3Q has a width of about 1 um. The Schottky barrier diode 5Q has a width of about 1 um. Even if the margin between wirings is taken into account, the wiring length from the Schottky barrier diode 5Q to the active region AR (MOSFET 1Q) can be set to about 10 um.

For example, assuming that a semiconductor chip having the MOSFET 1Q and a semiconductor chip having the shut-off function circuit 50 are in separate module forms, the wiring length from the shut-off function circuit 50 to the gate wiring GW would be at least about 5 cm. Assuming that a semiconductor chip having the MOSFET 1Q and a semiconductor chip having the shut-off function circuit 50 are in the same module form, the wiring length from the shut-off function circuit 50 to the gate wiring GW would be at least about 1 cm.

The wiring length in First Embodiment can therefore be reduced to about 1/1000 of the wiring length of the aforesaid module forms. Since the noise driving power by mutual inductance is "V=Mdφ/dt", the noise in First Embodiment can be reduced to about 1/1000 of the noise of these module forms.

As described above, a semiconductor device 100 with reduced loss can be provided, for example, by reducing the on resistance, according to First Embodiment. At the same time, the wiring inductance can be minimized and the short-circuit withstand time can be increased to 3 $\mu$sec or more. The semiconductor device 100 can therefore have improved performance and ensured reliability.

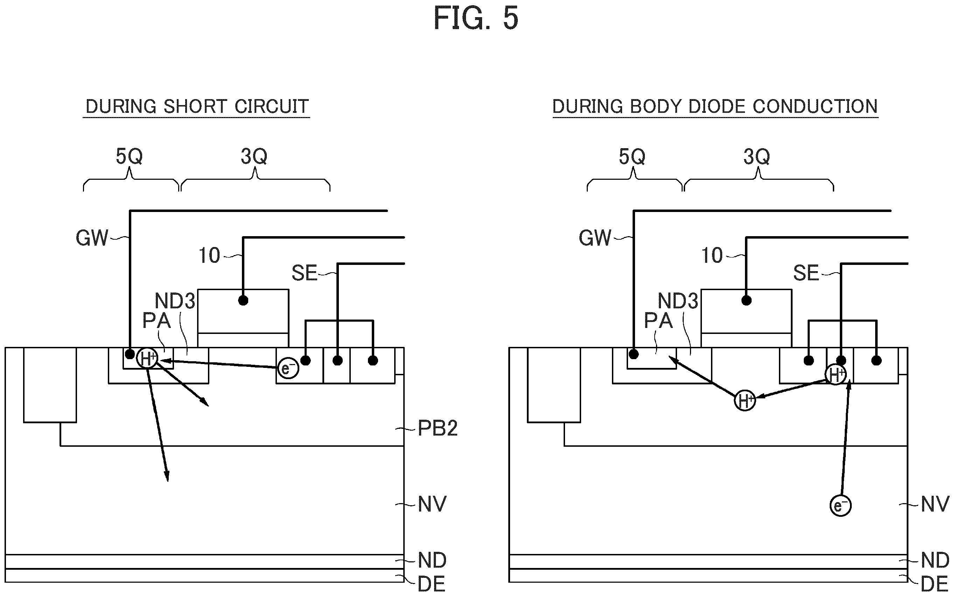

In addition, referring to Fig. 5, superiority of the Schottky barrier diode 5Q will hereinafter be described. Fig. 5 shows a problem that occurs when a PN diode is used instead of the Schottky barrier diode 5Q. This PN diode uses, as a cathode, the drain region ND3 and as an anode, a p type anode region PA formed in the drain region ND3.

As shown in Fig. 5, a bipolar current flows during short circuit, which may cause conduction, by pn junction, between the gate wiring GW and the drain electrode DE which were originally isolated. In addition, when a negative bias is applied to the gate wiring GW, conduction of a body diode occurs, but a positive hole can pass through the pn diode, which may cause conduction between the gate wiring GW and the source electrode SE.

For example, when the aforesaid module forms are used for the circuit constitution of the shut-off function circuit 50 and the MOSFET 1Q, the diode may be either a Schottky barrier diode or a pn diode. When the shut-off function circuit 50 and the MOSFET 1Q are formed on the same semiconductor substrate SUB as in First Embodiment, on the other hand, the problems as described above occur so that it is appropriate to use the Schottky barrier diode 5Q.

(First Modification)

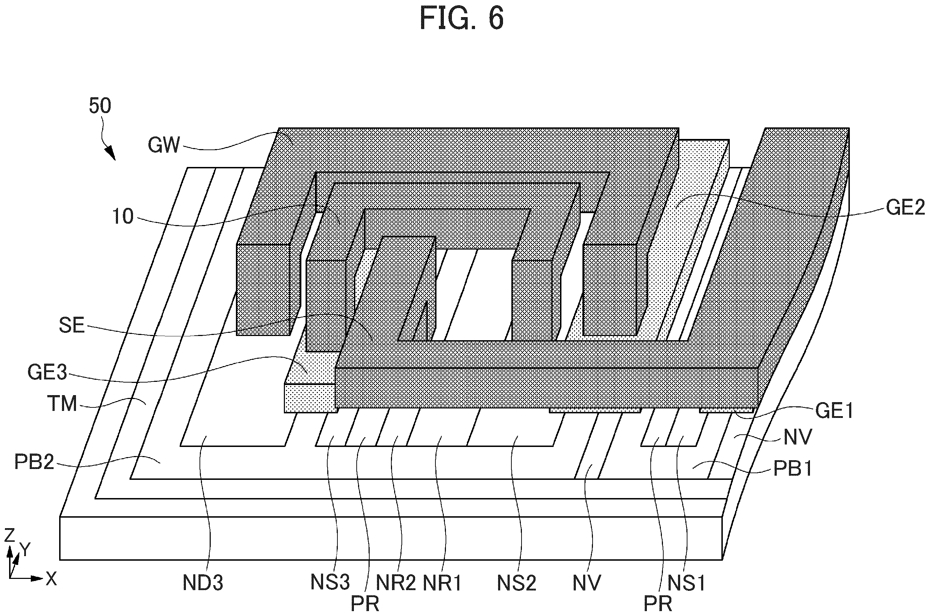

Fig. 6 shows First Modification of First Embodiment shown in Fig. 3. As shown in Fig. 3, in First Embodiment , any of the source electrode SE, the gate wiring GW, and the wiring 10 has a multilayer wiring structure. In First Modification, the source electrode SE, the gate wiring GW, and the wiring 10 are formed as the same layer. This means that the semiconductor substrate SUB has thereabove the first layer interlayer insulating film and the first layer interlayer insulating film has thereon the first-layer conductive material. The source electrode SE, the gate wiring GW, and the wiring 10 are each composed of the first-layer conductive material. Such a conductive material is composed of a stacked film of a titanium nitride film and an aluminum film formed on the titanium nitride film.

When a multilayer wiring structure as described in First Embodiment is used, wiring designing can be performed freely so as to reduce the wiring inductance, for example, by connecting the elements of the shut-off function circuit 50 with the shortest route.

In First Modification, on the other hand, the source electrode SE, the gate wiring GW, and the wiring 10 can be designed using only the first-layer conductive material and therefore, an increase of a manufacturing cost can be suppressed. In First Modification, a plane area for connecting the elements of the shut-off function circuit 50 is a little wider than that of First Embodiment and the width of the gate pad region Gwa is a little narrower. But the width is only about 30 um so that a sufficient area is ensured for the connection with external connection members.

(Second Embodiment)

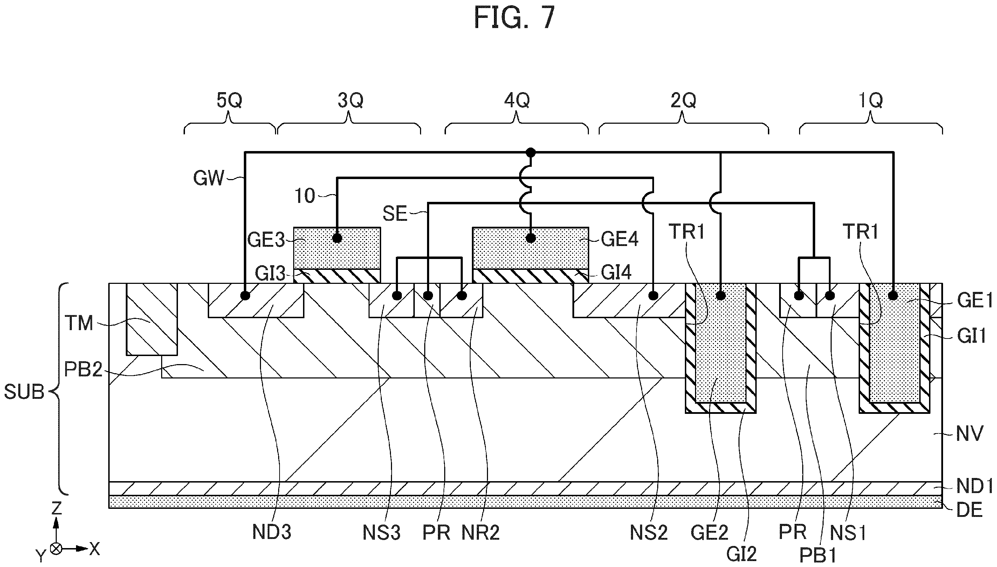

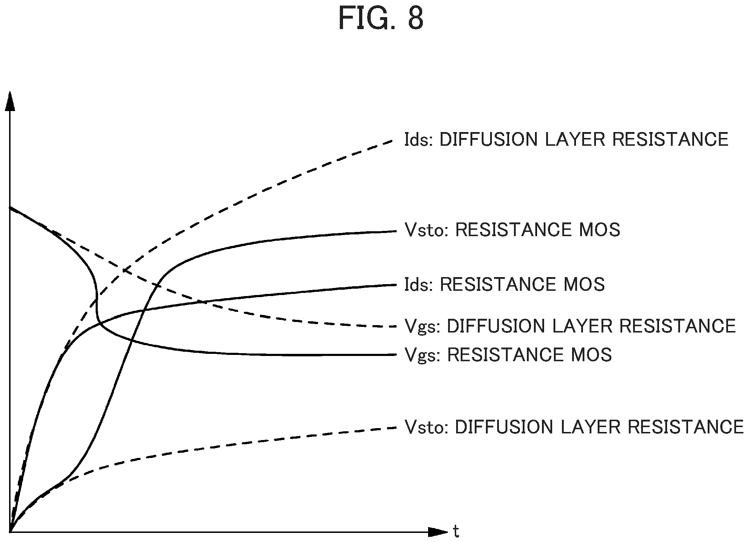

Referring to Fig. 7 and Fig. 8, a semiconductor device of Second Embodiment will hereinafter be described. It is to be noted that in the following description, a difference from First Embodiment will be described mainly and a description on a point that overlaps with First Embodiment will be omitted.

First Embodiment uses the diffusion region NR1 as the resistor element 4Q. In Second Embodiment, a MOSFET (resistance MOS) is used as the resistor element 4Q.

As shown in Fig. 7, this resistance MOS has a diffusion region NR2, a source region NS2, a gate insulating film GI4, and a gate electrode GE4. The gate electrode GE4 is on the semiconductor substrate SUB via the gate insulating film GI4. The gate insulating film GI4 is, for example, a silicon oxide film and the gate electrode GE4 is, for example, a polycrystalline silicon film having an n type impurity introduced therein.

The source region NS2 is electrically connected to the gate electrode GE3 with the wiring 10. The diffusion region NR2 is electrically connected to the source electrode SE. The gate electrode GE4 is electrically connected to the gate wiring GW.

As shown in Fig. 8, when the diffusion region NR1 is used as the resistor element 4Q (diffusion layer resistor), the potential Vsto of the wiring 10 increases in almost a linear form with respect to the drain current Ids. The saturation characteristic is therefore mild.

When the resistance MOS is used as the resistor element 4Q, on the other hand, the potential Vsto of the wiring 10 shows a rapid increase when it exceeds the saturation current value of the resistance MOS. The saturation characteristic thus obtained is almost flat and at the same time, is steep. This increases the on/off switching speed of the resistance MOS, leading to improvement in fault current suppression capacity at abnormal operation time. At normal operation time, on the other hand, almost no voltage occurs so that there is no adverse effect on the MOSFET 1Q. It is also an advantage that designers can easily set a short circuit current value as a saturation current value of the resistance MOS.

As shown in Fig. 7, the MOSFETs 1Q and 2Q may have a trench gate structure. In this case, the MOSFETs 1Q and 2Q have a trench TR11. The trench TR1 is formed in the semiconductor substrate SUB on the front surface side of the semiconductor substrate SUB to position its bottom portion below body regions PB1 and PB2. The gate insulating films GI1 and GI2 are formed on the front surface of the semiconductor substrate SUB inside the trench TR1. The gate electrodes GE1 and GE2 are formed on the gate insulating films GI1 and GI2 to embed the trench TR1 with them.

Both the MOSFETs 1Q and 2Q have a trench gate structure in Fig. 7, but alternatively, only one of them may have a trench gate type structure. In this case, the MOSFETs 1Q and 2Q can be designed individually and the threshold voltages of the MOSFETs 1Q and 2Q can be designed individually.

For example, to facilitate occurrence of a short channel effect in the MOSFET 2Q, the threshold voltage of the MOSFET 2Q may be adjusted. At abnormal operation time, a voltage as high as 1000 V occurs and only at this time, the threshold voltage of the MOSFET 2Q drops. As a result, a large current can be allowed to flow at abnormal operation time, leading to a drastic increase in the potential Vsto of the wiring 10 and improvement in fault current suppression capacity.

(Third Embodiment)

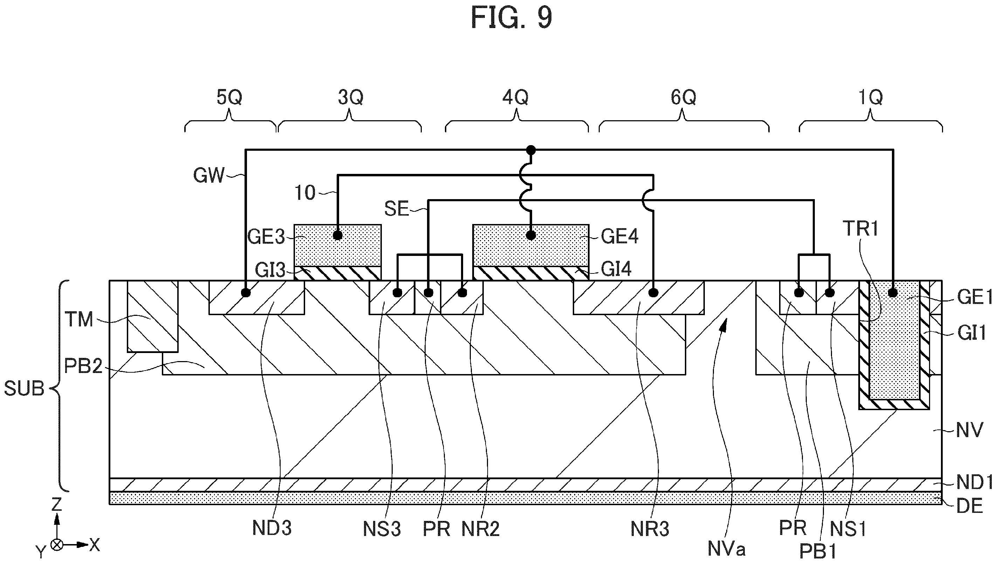

A semiconductor device of Third Embodiment will hereinafter be described using Figs. 9 to 11. In the following description, a difference from Second Embodiment will be described mainly and a point that overlaps with First Embodiment will be omitted.

In Second Embodiment, the MOSFET 2Q is used as a current detection element. In Third Embodiment, a JFET (Junction Field Effect Transistor) 6Q is used as a current detection element.

As shown in Fig. 9, the JFET 6Q has the body region PB1, the body region PB2, a diffusion region NR3, and the semiconductor substrate SUB (a JFET region NVa) between the body region PB1 and the body region PB2. The diffusion region NR3 extends from the body region PB2 to the JFET region NVa and is electrically connected to the gate electrode GE3 by the wiring 10. The diffusion region NR3 has an impurity concentration higher than that of the drift region NV.

Also in Third Embodiment, a MOSFET (resistance MOS) is used as the resistor element 4Q. It is to be noted that the resistance MOS of Third Embodiment has the diffusion region NR3 instead of the source region NS2. When the JFET 6Q is used, it is necessary to use not the diffusion region NR1 but the resistance MOS as the resistor element 4Q, because this embodiment does not include the gate electrode GE2.

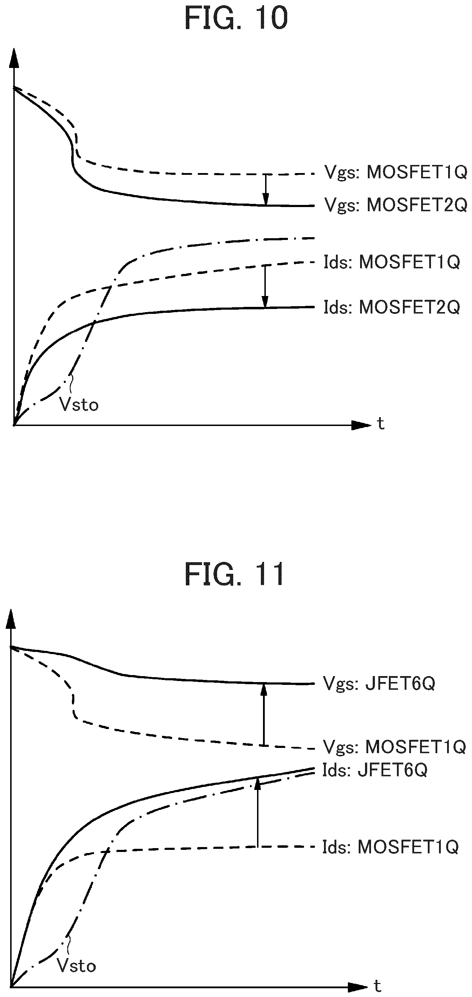

As shown in Fig. 10, in Second Embodiment, an increase in the potential Vsto of the wiring 10 causes not only a decrease in the potential of the gate wiring GW but also an increase in the source potential of the MOSFET 2Q and a reduction in the gate source voltage Vgs of the MOSFET 2Q. In this case, the gate source voltage Vgs of the MOSFET 2Q is more likely to shift significantly than that of the MOSFET 1Q in the active region AR. As the shut-off function circuit 50 operates, therefore, detection of a short circuit current becomes difficult, which causes a problem that prevents an excellent shut-off property from being achieved.

When in the MOSFET 2Q to be connected in parallel to the MOSFET 1Q, the shut-off function circuit 50 is realized by post processing, it is possible to connect the elements without causing a variation in the gate source voltage Vgs of the MOSFET 2Q because the elements are independent from each other. When the shut-off function circuit 50 is realized in the same semiconductor substrate SUB, on the other hand, the body potential is shared so that a variation in the gate source voltage Vgs of the MOSFET 2Q occurs. A structure that can be operated even under the influence of this potential variation is therefore required.

As shown in Fig. 10, when the MOSFET 2Q is used, an increase in the potential Vsto of the wiring 10 in addition to a reduction in the potential of the gate wiring GW occurs and therefore, the gate source voltage Vgs of the MOSFET 2Q decreases compared with that of the MOSFET 1Q. As a result, an increase in the drain current Ids of the MOSFET 2Q is suppressed and an increasing speed of the potential Vsto of the wiring 10 is slowed. This may prevent a sufficient reduction in the gate source voltage Vgs of the MOSFET 1Q.

In Third Embodiment, using the JFET 6Q instead of the MOSFET 2Q makes it possible to make a change in the gate source voltage Vgs smaller even if the shut-off function circuit 50 operates. As shown in Fig. 11, in the JFET 6Q, the gate potential is always 0 V (source potential) so that only an increase in the potential Vsto of the wiring 10 corresponds to a variation in the gate source voltage Vgs of the JFET 6Q and a drop in the drain current Ids does not occur compared with the MOSFET 1Q. As a result, the potential Vsto of the wiring 10 can effectively be raised and the gate source voltage Vgs of the MOSFET 1Q can be suppressed. In a region having a large gate source voltage Vgs, it is possible to realize a negative differential resistance in which the drain current Ids of the MOSFET 1Q decreases with an increase in the gate source voltage Vgs, which depends on the design.

(Fourth Embodiment)

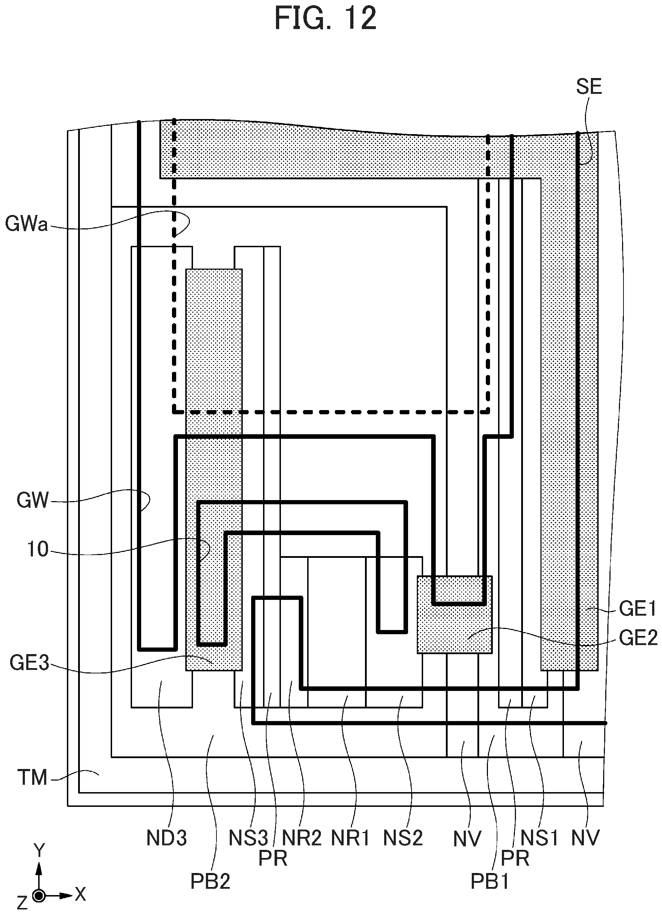

A semiconductor device of Fourth Embodiment will hereinafter be described referring to Fig. 12. In the following description, a difference from First Embodiment will mainly be described and a description on a point that overlaps with First Embodiment will be omitted.

How much the gate source voltage Vgs can be suppressed during short circuit can be calculated from the gate resistance Rg and the property of the MOSFET 3Q. The resistance value of the MOSFET 3Q is set at Rsto (Vsto). A gate source voltage Vgs to be applied to a MOSFET under a steady state can be calculated as shown in the following "Equation 1":

$$Vgs = Vgs\_GD \times Rsto/(R + Rsto) \qquad \text{Equation 1}$$

The potential Vsto of the wiring 10 increases when a large current flows to the MOSFET 2Q. As a result, the gate source voltage Vgs of the MOSFET 3Q increases, the resistance Rsto of the MOSFET 3Q decreases, and according to "Equation 1", the gate source voltage Vgs of the MOSFET 2Q approaches 0 V. When the gate source voltage Vgs of the MOSFET 3Q is negative, the Schottky barrier diode 5Q acts as an infinite resistance component so that even if a current flows, the gate source voltage Vgs of the MOSFET 2Q never approaches 0 V.

"Equation 1" indicates that the property design of the resistor Rsto of the MOSFET 3Q is required to correspond to the gate resistance Rg. For example, when the Vgs_GD is 15 V, assuming that the resistance Rsto changes from 1 Ω at abnormal time to 1000 Ω at normal time, the following would apply.

It can be understood that when Rg is 1 Ω, the gate source voltage Vgs of the MOSFET 3Q can change from 15.0 V to 7.5V. The short circuit can be suppressed sufficiently within this range.

It can be understood that when Rg is 1000 Ω, the gate source voltage Vgs of the MOSFET 3Q can change from 7.5V to 0.0 V. Within this range, unintended suppression of the gate source voltage Vgs may occur even at a low current.

It can be understood that when Rg is 0.1 Ω, the gate source voltage Vgs of the MOSFET 3Q can change from 15.0 to 14.9 V. Within this range, the gate source voltage Vgs cannot almost be suppressed even at short circuit.

These findings show that the system using the MOSFET 3Q has the following problem. First, the resistor Rsto of the MOSFET 3Q should have a property of the appropriate order for the gate resistance Rg. In general, the area of the shut-off function circuit 50 is desirably as small as possible in order to avoid narrowing of the area of the active region AR. In this case, however, the channel width of the MOSFET 3Q is three orders of magnitude smaller than that of the MOSFET 1Q, leading to an increase in channel resistance. In short, the resistor Rsto of the MOSFET 3Q increases.

A device to reduce the channel resistance of the MOSFET 3Q is therefore required. It is to be noted that the aforesaid problem is particularly marked in an SiC power MOSFET because the channel resistance is large. In addition, the SiC substrate itself is expensive so that a reduction in cost performance of the semiconductor device 100 is marked by narrowing the area of the active region AR.

Fig. 12 is a plan view of a semiconductor device 100 of Fourth Embodiment which is a means for overcoming the aforesaid problems.

Since connection with the source electrode SE cannot ordinarily be conducted directly below the gate pad region GWa of the gate wiring GW, the active region AR cannot be placed therein. In other words, the region directly below the gate pad region GWa is originally a region not used as the active region AR.

As shown in Fig. 12, in Fourth Embodiment, the MOSFET 3Q and the Schottky barrier diode 5Q are provided also directly below the gate pad region GWa. This means that the gate pad region GWa also has, directly therebelow, the body region PB2, the gate electrode GE3, the drain region ND3, the source region NS3, and the diffusion region PR.

This makes it possible to increase the channel width of the MOSFET 3Q without decreasing the area of the active region AR. This leads to a reduction in channel resistance of the MOSFET 3Q so that the aforesaid problem which will otherwise occur due to an increase in the resistor Rsto can be overcome. In other words, this enables the shut-off function circuit 50 to handle a sufficient amount of a current, leading to an improvement in fault current suppression capacity.

It is to be noted that the technology disclosed in Fourth Embodiment can be applied not only to First Embodiment but also to Second Embodiment and Third Embodiment.

(Second Modification)

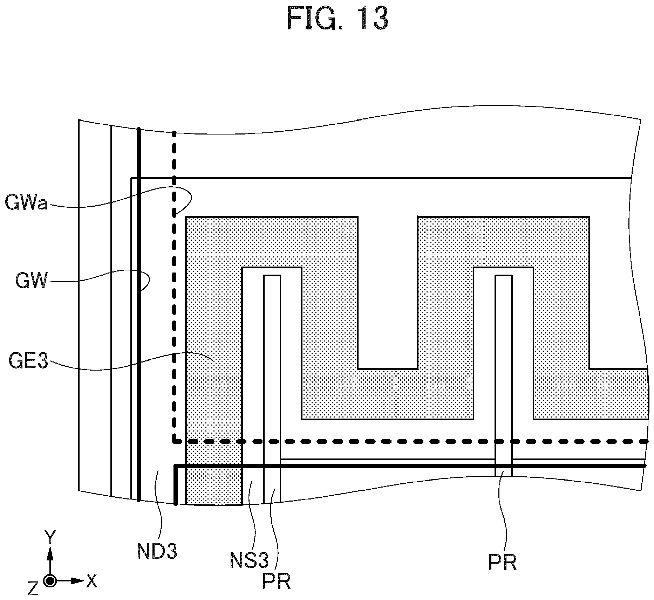

Fig. 13 shows Second Modification of Fourth Embodiment. In Second Modification, a device to increase the channel width of the MOSFET 3Q further is added.

As shown in Fig. 13, the gate electrode GE3 positioned directly below the gate pad region GWa is in a meandering form in a planar view. In other words, in the gate electrode GE3 placed directly below the gate pad region GWa, a portion extending in the direction Y and the other portion extending in the direction X form a continuous bent shape in which these portions are alternately connected with each other.

The drain region ND3 and the source region NS3 positioned directly below the gate pad region GWa extend along the gate electrode GE3 to sandwich, between them, the body region PB2 below the gate electrode GE3. This makes it possible to increase the channel width of the MOSFET 3Q further without decreasing the area of the active region AR.

As in Fourth Embodiment, the technology disclosed in Second Modification can be applied not only to First Embodiment but also to Second Embodiment and Third Embodiment.

(Fifth Embodiment)

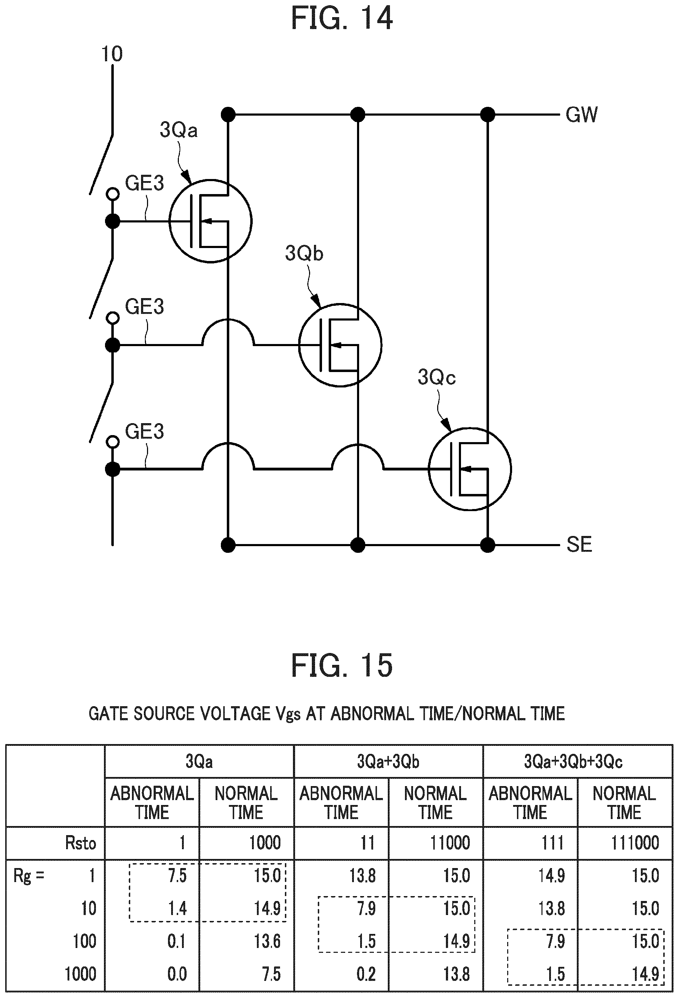

A semiconductor device of Fifth Embodiment will hereinafter be described referring to Fig. 14 and Fig. 15. In the following description, a difference from First Embodiment will be described mainly and a description on a point that overlaps with First Embodiment will be omitted.

As shown in Fig. 14, a plurality of MOSFETs 3Q is provided in Fifth Embodiment and they are shown as MOSFETs 3Qa, 3Qb, and 3Qc which are connected in parallel to each other. The wiring 10 has thereon switches and connection between the respective gate electrodes GE3 of the MOSFETs 3Qa, 3Qb, and 3Qc and the wiring 10 can be switched as needed by these switches. The MOSFET 3Q whose connection with the wiring 10 has been shut off by the switch loses conduction and the channel width of the MOSFET 3Q is omitted from the calculation.

It is to be noted that the switch may be formed using a semiconductor element such as another MOSFET or it may be realized by cutting the wiring 10 by a laser or the like.

In such a manner, by adjusting the state of the switch appropriately according to the gate resistance Rg during use, even a semiconductor chip with a single design can be applied to a plurality of applications to enhance versatility.

Described specifically, realization of the shut-off function circuit 50 on the same semiconductor substrate SUB is accompanied with a problem of deteriorated versatility because the specification cannot be adjusted by the replacement of an electronic part as performed in a later step. For example, for manufacturing 10 kinds of products having respective specifications, it is only necessary to manufacture one semiconductor chip and satisfy these specifications by replacement of an electronic part. When the shut-off function circuit 50 is realized using the same semiconductor substrate SUB, on the other hand, 10 kinds of semiconductor chips should be manufactured. Even if the same semiconductor substrate SUB is used, versatility can be enhanced further when the semiconductor substrate SUB can be applied to products with various specifications.

In Fifth Embodiment, since the MOSFETs 3Qa, 3Qb, and 3Qc are caused to have respectively different gate widths, they have respectively different channel widths and respectively different resistance Rsto values.

Fig. 15 is a graph showing a correspondence relation of the synthesized MOSFET 3Q between the gate source voltage Vgs and a change in the gate resistance Rg in the cases where the resistance Rsto value of the MOSFET 3Qc is about 10 times larger than the resistance Rsto value of the MOSFET 3Qb and the resistance Rsto value of the MOSFET 3Qb is about 10 times larger than the resistance Rsto value of the MOSFET 3Qa.

For example, when the Vgs_GD is 15 V and the gate resistance Rg is 1 Q; and the MOSFET 3Q is composed only of the MOSFET 3Qa, the resistance Rsto changes from 1 Q at abnormal time to 1000 Q at normal time. At this time, the gate source voltage Vgs of the MOSFET 3Q can change from 15.0 V to 7.5 V. Within this range, short circuit can be suppressed sufficiently. Even when the gate resistance Rg is 10 Ω, such a constitution permits the gate source voltage Vgs to change from 14.9 V to 1.4 V and the shut-off function circuit 50 is able to stand up to the specification.

In the table shown in Fig. 15, the broken line shows the range of the shut-off function circuit 50 that can stand up to the specification. Similarly, even if the gate resistance Rg is another value such as 100 Ω or 1000 Ω, the short circuit can be suppressed appropriately by using a plurality of MOSFETs, that is, 3Qa, 3Qb, and 3Qc in combination. Thus, the semiconductor device obtained in Fifth Embodiment has enhanced versatility. The number of the MOSFET 3Q is not limited to three (MOSFETs 3Qa, 3Qb, and 3Qc) but it may be four or more. As the number is larger, correspondence to various gate resistances Rg can be enhanced.

The technology disclosed in Fifth Embodiment may be applied to not only First Embodiment abut also to Embodiments 2 to 4.

(Sixth Embodiment)

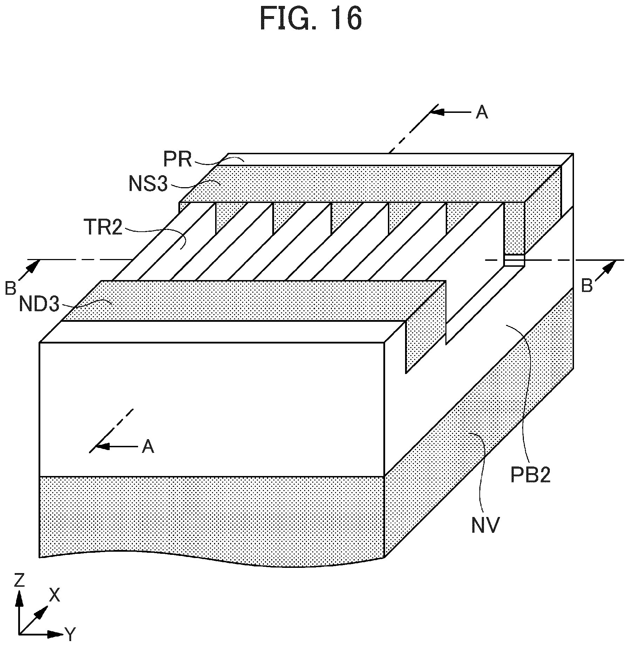

A semiconductor device of Sixth Embodiment will hereinafter be described referring to Figs. 16 to 18. In the following description, a difference from First Embodiment will be described mainly and a description on a point that overlaps with First Embodiment will be omitted.

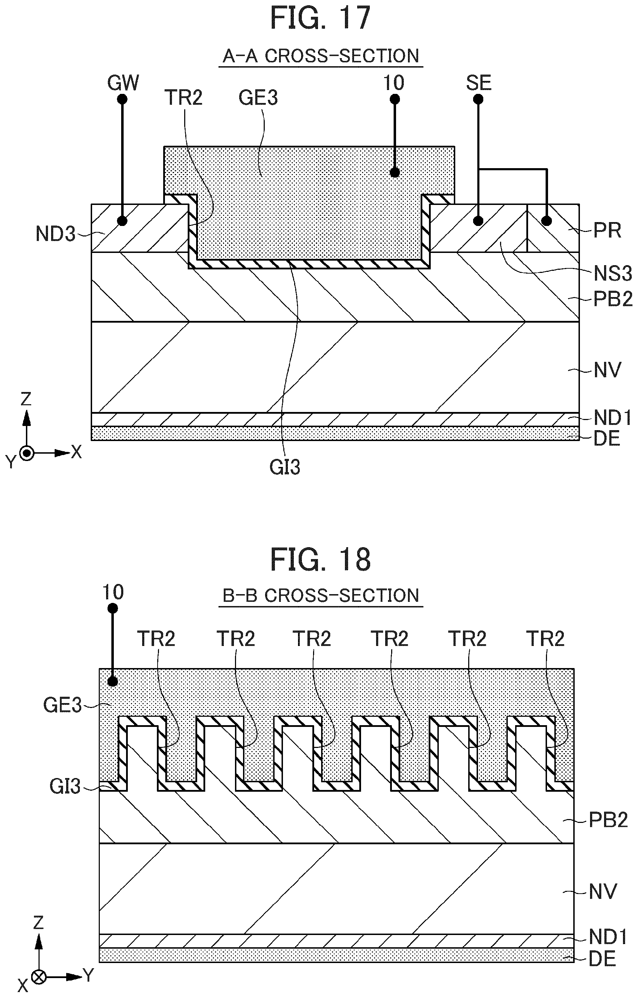

Fig. 16 is a perspective view showing a modification of the MOSFET 3Q which is an overcurrent shut-off element. Fig. 17 is a cross-sectional view taken along the line A-A shown in Fig. 16. Fig. 18 is a cross-sectional view taken along the line B-B shown in Fig. 16. It is to be noted that to facilitate understanding of the constitution of a trench TR2, the gate insulating film GI3 and the gate electrode GE3 are omitted from the drawings.

In Sixth Embodiment, as shown in Figs. 16 to 18, on the front surface side of the semiconductor substrate SUB, the semiconductor substrate SUB has a plurality of trenches TR2 therein. The MOSFET 3Q has a plurality of the trenches TR2; the trenches TR2 are positioned between the drain region ND3 and the source region NS3; and the trenches TR2 each have a bottom portion in the body region PB2.

The gate insulating film GI3 is formed on the front surface of the semiconductor substrate SUB inside the trenches TR2. The gate electrode GE3 is formed on the gate insulating film GI3 to embed the trenches TR2 therewith.

This means that the body region PB2 positioned between the trenches TR2 constitutes a channel region of the MOSFET 3Q. When Sixth Embodiment and First Embodiment are compared with the same plane area, therefore, the channel width of the MOSFET 3Q increases largely. Then, because of the reason as described in Fourth Embodiment, the channel resistance of the MOSFET 3Q can be reduced so that the problem due to an increase in the resistance of the resistor Rsto can be overcome. This enables the shut-off function circuit 50 to handle a further larger current amount, leading to a further improvement in fault current suppression capacity.

It is to be noted that the technology disclosed in Sixth Embodiment can be applied to not only First Embodiment but also to Embodiments 2 to 5.

The present invention has been described above specifically based on the aforesaid embodiments. The present invention is however not limited by the aforesaid embodiments but can be changed in various ways without departing from the gist of the invention. Reference Signs List

1Q to 3Q, 3a, 3b, 3c: MOSFET
4Q: resistor element
5Q: Schottky barrier diode
6Q: JFET
AR: active region
GE1 to GE4: gate electrode
GI1 to GI4: gate insulating film
GW: gate wiring
Gwa: gate pad region
ND1, ND3: drain region
NR1 to NR3: diffusion region
NS1 to NS3: source region
NV: drift region
NVa: JFET region
PA: anode region
PB1, PB2: body region
SE: source region
SUB: semiconductor substrate
TM: termination region
TR: trench
10: wiring
50: shut-off function circuit
100: semiconductor device

**Claims**

1. A semiconductor device, comprising:

an n type semiconductor substrate having a front surface and a back surface and having silicon carbide;
a source electrode, a gate wiring, and a first wiring formed over the front surface of the semiconductor substrate;
a p type first body region formed in the semiconductor substrate on the front surface side of the semiconductor substrate;
a p type second body region formed in the semiconductor substrate on the front surface side of the semiconductor substrate;
a drain electrode formed below the back surface of the semiconductor substrate;
a first MOSFET;
a second MOSFET;
a third MOSFET;
a Schottky barrier diode; and
a resistor element, wherein
the first MOSFET comprises:

an n type first source region formed in the first body region;
an n type first drain region formed, on the back surface side of the semiconductor substrate, in the semiconductor substrate and electrically connected to the drain electrode; and
a first gate electrode formed over the front surface of the semiconductor substrate via a first gate insulating film,

the second MOSFET comprises:

an n type second source region formed in the second body region;

the first drain region; and
a second gate electrode formed over the front surface of the semiconductor substrate via a second gate insulating film,

the third MOSFET comprises:

an n type third source region formed in the second body region;
an n type third drain region formed in the second body region; and
a third gate electrode formed over the front surface of the semiconductor substrate via a third gate insulating film,

the Schottky barrier diode is constituted by Schottky junction of a conductive material contained in the gate wiring and the third drain region,
the gate wiring is electrically connected to the first gate electrode, the second gate electrode, and the third drain region,
the source electrode is electrically connected to the first source region, the third source region, the first body region, the second body region, and the resistor element,
the second source region is electrically connected to the third source region and the source electrode via the resistor element,
the third gate electrode is electrically connected to the second source region by the first wiring, and
the second MOSFET, the third MOSFET, the Schottky barrier diode, and the resistor element constitute a shut-off function circuit that detects an overcurrent flowing to the first MOSFET and limits the overcurrent.

2. The semiconductor device according to Claim 1, further comprising:
a p type termination region formed in the semiconductor substrate on the front surface side of the semiconductor substrate to surround the first MOSFET and the shut-off function circuit in a planar view.

3. The semiconductor device according to Claim 1, wherein
the resistor element has an n type first diffusion region formed in the second body region and having an impurity concentration lower than that of the third source region.

4. The semiconductor device according to Claim 1, wherein

the resistor element has a fourth MOSFET,
the fourth MOSFET comprises:

an n type second diffusion region formed in the second body region;
the second source region; and
a fourth gate electrode formed over the front surface of the semiconductor substrate via a fourth gate insulating film,

the second diffusion region is electrically connected to the source electrode, and
the fourth gate electrode is electrically connected to the gate wiring.

5. The semiconductor device according to Claim 4, further comprising:

a first trench formed in the semiconductor substrate on the front surface side of the semiconductor substrate such that a bottom portion of the first trench lower than the first body region or the second body region, wherein the first MOSFET or the second MOSFET has the first trench,
the first gate insulating film or the second gate insulating film is formed over the front surface of the semiconductor substrate in the first trench, and
the first gate electrode or the second gate electrode is formed over the first gate insulating film or the second gate insulating film so as to embed the first trench.

6. The semiconductor device according to Claim 1, wherein

the gate wiring has a gate pad region for connecting the gate wiring to an external connection member, and
the third MOSFET and the Schottky barrier diode are provided also directly below the gate pad region.

7. The semiconductor device according to Claim 6, wherein

the third gate electrode placed directly below the gate pad region is in a meandering form in a planar view, and
the third drain region and the third source region placed directly below the gate pad region are formed to extend
along the third gate electrode so as to sandwich the second body region below the third gate electrode.

8. The semiconductor device according to Claim 1, wherein

the number of the third MOSFET provided in the device is plural,
the third MOSFETs are connected in parallel to each other,
the third MOSFETs have respectively different gate widths, and
connection of the third gate electrode of each of the third MOSFETs with the first wiring is switchable as needed.

9. The semiconductor device according to Claim 1, wherein
the source electrode, the gate wiring, and the first wiring are formed as the same layer.

10. The semiconductor device according to Claim 1, further comprising:

a plurality of second trenches formed in the semiconductor substrate on the front surface side of the semiconductor substrate such that a bottom portion of the second trenches is arranged in the second body region,
wherein
the third MOSFET has the second trenches,
the third gate insulating film is formed over the front surface of the semiconductor substrate in the second
trenches, and
the third gate electrode is formed over the third gate insulating film to embed the second trenches with the third
gate electrode.

11. A semiconductor device, comprising:

an n type semiconductor substrate having a front surface and a back surface and having silicon carbide;
a source electrode, a gate wiring, and a first wiring formed over the front surface of the semiconductor substrate;
a p type first body region formed in the semiconductor substrate on the front surface side of the semiconductor
substrate;
a p type second body region formed in the semiconductor substrate on the front surface side of the semiconductor
substrate;
a drain electrode formed below the back surface of the semiconductor substrate;
a first MOSFET;
a third MOSFET;
a JFET;
a Schottky barrier diode; and
a resistor element, wherein
the first MOSFET comprises:

an n type first source region formed in the first body region;
an n type first drain region formed in the semiconductor substrate on the back surface side of the
semiconductor substrate and electrically connected to the drain electrode; and
a first gate electrode formed over the front surface of the semiconductor substrate via a first gate insulating
film,

the third MOSFET comprises:

an n type third source region formed in the second body region;
an n type third drain region formed in the second body region; and
a third gate electrode formed over the front surface of the semiconductor substrate via a third gate insulating
film,

the resistor element is constituted by a fourth MOSFET,
the fourth MOSFET comprises:

an n type second diffusion region formed in the second body region;

an n type third diffusion region extending from the second body region to the semiconductor substrate between the first body region and the second body region; and

a fourth gate electrode formed over the front surface of the semiconductor via a fourth gate insulating film,

the JFET comprises:

the first body region;

the second body region;

the third diffusion region; and

the semiconductor substrate between the first body region and the second body region,

the Schottky barrier diode is constituted by Schottky junction of a conductive material contained in the gate wiring and the third drain region,

the gate wiring is electrically connected to the first gate electrode, the fourth gate electrode, and the third drain region,

the source electrode is electrically connected to the first source region, the third source region, the second diffusion region, the first body region, and the second body region,

the third gate electrode is electrically connected to the third diffusion region by the first wiring, and

the JFET, the third MOSFET, the Schottky barrier diode, and the resistor element constitute a shut-off function circuit that detects an overcurrent flowing to the first MOSFET and limits the overcurrent.

12. The semiconductor device according to Claim 11, further comprising:
a p type termination region formed in the semiconductor substrate on the front surface side of the semiconductor substrate to surround the first MOSFET and the shut-off function circuit in a planar view.

13. The semiconductor device according to Claim 11, further comprising:

a first trench formed in the semiconductor substrate on the front surface side of the semiconductor substrate to such that a bottom portion of the first trench is positioned lower than the first body region, wherein
the first MOSFET has the first trench,
the first gate insulating film is formed over the front surface of the semiconductor substrate in the first trench, and
the first gate electrode is formed over the first gate insulating film to embed the first trench with the first gate electrode.

14. The semiconductor device according to Claim 11, wherein

the gate wiring has a gate pad region for connecting the gate wiring to an external connection member, and
the third MOSFET and the Schottky barrier diode are provided also directly below the gate pad region.

15. The semiconductor device according to Claim 14, wherein

the third gate electrode placed directly below the gate pad region is in a meandering form in a planar view, and
the third drain region and the third source region placed directly below the gate pad region are formed to extend along the third gate electrode so as to sandwich the second body region below the third gate electrode.

16. The semiconductor device according to Claim 11, wherein

the number of the third MOSFET provided in the device is plural,
the third MOSFETs are connected in parallel to each other,
the third MOSFETs have respectively different gate widths, and
connection of the third gate electrode of each of the MOSFETs with the first wiring is switchable as needed.

17. The semiconductor device according to Claim 11, further comprising:

a plurality of second trenches formed in the semiconductor substrate on the front surface side of the semiconductor substrate such that a bottom portion of the second trenches is arranged in the second body region, wherein

the third MOSFET has the second trenches,

the third gate insulating film is formed over the front surface of the semiconductor substrate in the second trenches, and

the third gate electrode is formed over the third gate insulating film to embed the second trenches with the third gate electrode.

FIG. 1

FIG. 2

# FIG. 3

EP 4 485 546 A1

FIG. 4

# FIG. 5

DURING SHORT CIRCUIT

DURING BODY DIODE CONDUCTION

FIG. 6

# FIG. 7

EP 4 485 546 A1

# FIG. 8

Ids: DIFFUSION LAYER RESISTANCE

Vsto: RESISTANCE MOS

Ids: RESISTANCE MOS

Vgs: DIFFUSION LAYER RESISTANCE

Vgs: RESISTANCE MOS

Vsto: DIFFUSION LAYER RESISTANCE

t

EP 4 485 546 A1

# FIG. 9

EP 4 485 546 A1

## FIG. 10

Vgs: MOSFET1Q
Vgs: MOSFET2Q
Ids: MOSFET1Q
Ids: MOSFET2Q
Vsto
t

## FIG. 11

Vgs: JFET6Q
Vgs: MOSFET1Q
Ids: JFET6Q
Ids: MOSFET1Q
Vsto
t

# FIG. 12

# FIG. 13

# FIG. 14

# FIG. 15

GATE SOURCE VOLTAGE Vgs AT ABNORMAL TIME/NORMAL TIME

| | | 3Qa | | 3Qa+3Qb | | 3Qa+3Qb+3Qc | |
|---|---|---|---|---|---|---|---|
| | | ABNORMAL TIME | NORMAL TIME | ABNORMAL TIME | NORMAL TIME | ABNORMAL TIME | NORMAL TIME |
| Rsto | | 1 | 1000 | 11 | 11000 | 111 | 111000 |
| Rg = | 1 | 7.5 | 15.0 | 13.8 | 15.0 | 14.9 | 15.0 |
| | 10 | 1.4 | 14.9 | 7.9 | 15.0 | 13.8 | 15.0 |
| | 100 | 0.1 | 13.6 | 1.5 | 14.9 | 7.9 | 15.0 |
| | 1000 | 0.0 | 7.5 | 0.2 | 13.8 | 1.5 | 14.9 |

FIG. 16

# FIG. 17

<u>A-A CROSS-SECTION</u>

GW  TR2  GE3  10  SE

ND3  PR

NS3

PB2

NV

ND1

DE

GI3

Z
Y⊙→X

# FIG. 18

10  <u>B-B CROSS-SECTION</u>

TR2  TR2  TR2  TR2  TR2  TR2

GE3

GI3

PB2

NV

ND1

DE

Z
X⊗→Y

# INTERNATIONAL SEARCH REPORT

International application No.

**PCT/JP2022/031134**

### A. CLASSIFICATION OF SUBJECT MATTER

***H01L 29/78***(2006.01)i; ***H01L 29/12***(2006.01)i; ***H01L 29/47***(2006.01)i; ***H01L 29/872***(2006.01)i
FI: H01L29/78 657G; H01L29/78 657F; H01L29/78 657A; H01L29/78 652S; H01L29/78 652Q; H01L29/78 652T; H01L29/86 301D; H01L29/86 301M; H01L29/48 M; H01L29/78 653A; H01L29/78 652F; H01L29/78 656A; H01L29/78 656B

According to International Patent Classification (IPC) or to both national classification and IPC

### B. FIELDS SEARCHED

Minimum documentation searched (classification system followed by classification symbols)

H01L29/78; H01L29/12; H01L29/47; H01L29/872

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2006-12960 A (RENESAS TECHNOLOGY CORP.) 12 January 2006 (2006-01-12) paragraphs [0016]-[0042], fig. 1, 3, 5 | 1-17 |
| A | JP 2012-243930 A (RENESAS ELECTRONICS CORP.) 10 December 2012 (2012-12-10) paragraphs [0013]-[0023], fig. 1, 2 | 1-17 |
| A | JP 2000-299634 A (YAZAKI CORP.) 24 October 2000 (2000-10-24) paragraphs [0071]-[0096], fig. 9 | 1-17 |
| A | JP 2018-82207 A (FUJI ELECTRIC CO., LTD.) 24 May 2018 (2018-05-24) paragraphs [0002]-[0014], fig. 9 | 1-17 |
| A | JP 6-29539 A (PHILIPS ELECTRONICS NAAMLOZE VENNOOTSCHAP) 04 February 1994 (1994-02-04) paragraphs [0055]-[0058], fig. 11 | 1-17 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 October 2022** | **25 October 2022** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (January 2015)

INTERNATIONAL SEARCH REPORT
Information on patent family members

International application No.

**PCT/JP2022/031134**

| Patent document cited in search report | | | Publication date (day/month/year) | Patent family member(s) | | Publication date (day/month/year) |
|---|---|---|---|---|---|---|
| JP | 2006-12960 | A | 12 January 2006 | US 2005/0286194 A1 paragraphs [0020]-[0055], fig. 1, 3, 5 | | |
| JP | 2012-243930 | A | 10 December 2012 | (Family: none) | | |
| JP | 2000-299634 | A | 24 October 2000 | US 6392859 B1 column 19, line 44 to column 28, line 38, fig. 7A EP 1028467 A2 | | |
| JP | 2018-82207 | A | 24 May 2018 | (Family: none) | | |
| JP | 6-29539 | A | 04 February 1994 | US 5442216 A column 9, line 48 to column 10, line 14, fig. 11 EP 565179 A2 | | |

Form PCT/ISA/210 (patent family annex) (January 2015)

**EP 4 485 546 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003332446 A